(19) Europäisches Patentamt

European Patent Office

Office européen des brevets

(11) **EP 0 641 074 B1**

(12) **EUROPÄISCHE PATENTSCHRIFT**

(45) Veröffentlichungstag und Bekanntmachung des Hinweises auf die Patenterteilung:
**08.07.1998  Patentblatt 1998/28**

(51) Int Cl.$^6$: **H03H 19/00**

(21) Anmeldenummer: **94113220.1**

(22) Anmeldetag: **24.08.1994**

(54) **Switched-Capacitor-Netzwerk**

Switched-capacitor circuit

Circuit à capacités commutées

(84) Benannte Vertragsstaaten:
**AT BE CH DE FR GB IT LI**

(30) Priorität: **27.08.1993  DE 4328974**

(43) Veröffentlichungstag der Anmeldung:
**01.03.1995  Patentblatt 1995/09**

(73) Patentinhaber: **SIEMENS AKTIENGESELLSCHAFT**
**80333 München (DE)**

(72) Erfinder:
- **Koch, Rudolf, Dr.-Ing.**
  **D-82041 Oberhaching (DE)**
- **Alger-Meunier, Michael, Dipl.-Ing.**
  **D-85540 Haar (DE)**

(56) Entgegenhaltungen:
**EP-A- 0 396 786        EP-A- 0 396 787**

**Beschreibung**

Die Erfindung betrifft ein Switched-Capacitor-Netzwerk mit einer Schalteinrichtung, die zwei erste Kondensatoren gleicher Kapazität abwechselnd aus einer Signalspannungsquelle mit gegenüber einem Bezugspotential entgegengesetzten Polaritäten auflädt und anschließend über jeweils einen Eingangskreis eines Differenzverstärkers entlädt und die synchron dazu jeweils zwei zweite Kondensatoren gleicher Kapazität abwechselnd und zueinander gegenphasig aus einer Referenzspannungsquelle mit gegenüber dem Bezugspotential gleichen Polaritäten auflädt und anschließend über jeweils einen Eingangskreis des Differenzverstärkers entlädt.

Aktive Netzwerke benötigen zu ihrer Realisierung üblicherweise als aktives Bauelement einen Operationsverstärker sowie als passive Elemente Kondensatoren und Widerstände. Die Frequenzabhängigkeit des Netzwerkes wird dabei durch die verwendeten Kondensatoren und Widerstände bestimmt. Bei Switched-Capacitor-Netzwerken dagegen werden Widerstände durch geschaltete Kondensatoren simmuliert, wobei ein linearer Zusammenhang zwischen der Schaltfrequenz und dem einem ohmschen Widerstand entsprechenden äquivalenten Leitwert besteht. Damit kann auf einfache Weise durch Variation der Schaltfrequenz die Frequenzabhängigkeit des Netzwerkes verändert werden.

Üblicherweise werden die Kondensatoren eines Switched-Capacitor-Netzwerkes derart geschaltet, daß sie jeweils in einer Schaltphase geladen und in der darauffolgenden Schaltphase wiederum entladen werden. Anstelle des Entladens kann dabei auch ein Umladen treten, was einem Entladen mit anschließendem Aufladen entgegengesetzter Polarität entspricht. Der Beginn des Auf- bzw. Umladevorgangs stellt für die ladende Spannungsquelle eine starke Belastung dar, da der Kondensator kurzzeitig einen Kurzschluß bildet und der Strom hauptsächlich nur durch den Innenwiderstand der Spannungsquelle und den Übergangswiderstand der Schalteinrichtung begrenzt wird. Die Folge davon ist ein zunächst auftretender Spannungseinbruch an der Spannungsquelle und nachfolgend ein im wesentlichen durch die Kapazität des Kondensators, den Innenwiderstand der Spannungsquelle sowie den Übergangswiderstand der Schalteinrichtung bestimmter Einschwingvorgang. Dies kann jedoch zu einer unzureichenden Aufladung des jeweiligen Kondensators innerhalb der entsprechenden Schaltphase und zu daraus resultierenden Störungen des gesamten Netzwerkes führen.

Weist ein Switched-Capacitor-Netzwerk einen (zusätzlichen) Signalpfad mit einem weiteren Kondensator auf, der mit dem bereits vorhandenen Pfad gekoppelt und auf einen (Differenz-)Verstärker geführt ist, so kann außerdem die Aufladung des einen Kondensators vom Signal im Signalpfad abhängig sein. Ein derartiges Netzwerk ist beispielsweise durch einen in der Europäischen Patentanmeldung 0 396 786 beschriebenen Sigma-Delta-Modulator gegeben.

Dabei werden zwei identische Kondensatoren im Signalpfad abwechselnd aus einer gegenüber einem Bezugspotential symmetrischen Signalspannungsquelle aufgeladen und anschließend über entsprechende Differenzeingänge eines Differenzverstärkers entladen. Mit dem Signalpfad gekoppelt ist ein Rückkopplungspfad, der im wesentlichen aus einem durch das Ausgangssignal des Sigma-Delta-Modulators angesteuerten Digital-Analog-Wandler besteht. Der Digital-Analog-Wandler ist ebenfalls differentiell ausgeführt und benötigt daher auch differentielle Referenzspannungen. Anstelle einer bipolaren Spannungsquelle wird jedoch nur eine unipolare Spannungsquelle verwendet und es werden dafür die beiden Kondensatoren des Digital-Analog-Wandlers im Rückkopplungspfad gegenphasig zueinander geladen und entladen.

Problematisch ist dabei jedoch, daß die zur Ladung der Kondensatoren im Rückkopplungspfad eingesetzte Referenzspannungsquelle üblicherweise aus einer Regelschaltung, beispielsweise einem entsprechend beschalteten Operationsverstärker, besteht. In einer ersten Schaltphase liegt am Koppelpunkt von Signal- und Rückkopplungspfad nur das Signal an und der Operationsverstärker eines nachfolgenden Integrierers ist abgekoppelt. In dieser Phase wird einer der beiden Kondensatoren im Rückkopplungspfad aufgeladen, jedoch ohne größere Auswirkungen auf den zugehörigen Koppelpunkt. In der nachfolgenden zweiten Schaltphase wird der andere Kondensator im Rückkopplungspfad aufgeladen und zwar über den Eingangskreis des nachfolgenden, als Integrierer beschalteten Operationsverstärkers, auf den auch die Kondensatoren im Signalpfad aufgeschaltet sind. Dieser regelt folglich in Abhängigkeit vom Signal die Knotenpunkte gegen das Bezugspotential aus. Dieser Vorgang wird über den aufgeschalteten Kondensator im Rückkopplungszweig auf die Referenzspannungsquelle abgebildet. In der Regel hat der Operationsverstärker der Referenzspannungsquelle jedoch eine wesentlich geringere Bandbreite als der Operationsverstärker des Integrierers, so daß die durch das Signal hervorgerufenen Störungen der Referenzspannungsquelle nicht ausgeregelt werden können.

Aufgabe der Erfindung ist es daher, ein Switched-Capacitor-Netzwerk anzugeben, bei dem signalabhängige Störungen der Referenzspannungsquelle unterdrückt werden.

Die Aufgabe wird bei einem Switched-Capacitor-Netzwerk der eingangs genannten Art durch zwei dritte Kondensatoren mit gleicher Kapazität wie die zweiten Kondensatoren, die durch die Schalteinrichtung gegenphasig zu den jeweils entsprechenden zweiten Kondensatonren aus der Referenzspannungsquelle mit gegenüber dem Bezugspotential gleichen Polaritäten und anschließend über jeweils einen Eingangskreis des Differenzverstärkers entladen werden, gelöst.

Eine Weiterbildung der Erfindung sieht zwei vierte Kondensatoren vor, die mittels einer zusätzlichen Schalteinrichtung jeweils synchron zu einem der beiden zweiten Kondensatoren geladen und entladen werden und die zum Laden zwischen die Referenzspannungsquelle und eine weitere Referenzspannungsquelle geschaltet werden, wobei das Produkt aus der Kapazität jedes zweiten Kondensators und der Spannung der ersten Referenzspannungsquelle gleich dem Produkt aus der Kapazität jedes vierten Kondensators und der Spannungsdifferenz beider Spannungsquellen ist und das Produkt aus der Kapazität jedes zweiten Kondensators und dem Übergangswiderstand der Schalteinrichtung im jeweiligen Zuleitungspfad gleich dem Produkt aus der Kapazität jedes vierten Kondensators und der Summe des Innenwiderstandes der weiteren Referenzspannungsquelle und des Übergangswiderstandes der weiteren Schalteinrichtung im Zuleitungspfad jedes vierten Kondensators ist.

Der signalunabhängige Spannungseinbruch beim Aufschalten des ersten Kondensators mittels der ersten Schalteinrichtung und der daran anschließende Einschwingvorgang werden also dadurch kompensiert, daß mit Hilfe der zweiten Spannungsquelle in Verbindung mit dem zweiten Kondensator und der zweiten Schalteinrichtung ein gegenpoliger, ansonsten jedoch identischer Spannungsverlauf erzeugt und dem Verlauf an der ersten Spannungsquelle überlagert wird.

Üblicherweise sind die auf den Zuleitungen auftretenden Widerstände (bzw. Impedanzen) vernachläßigbar gegenüber dem Innenwiderstand der Spannungsquellen und dem Übergangswiderstand der Schalteinrichtung. Sie sind daher im allgemeinen auch ohne Einfluß auf die Funktion des Netzwerkes. Sollte dies jedoch nicht der Fall sein, so ist folglich auch eine Anpassung der Widerstände (Impedanzen) der Zuleitungen und ggf. weiterer Widerstände (Impedanzen) zwischen der zweiten Spannungsquelle und dem zweiten Kondensator an entsprechende Widerstände (Impedanzen) zwischen der ersten Spannungsquelle und dem ersten Kondensator erforderlich. Darüber hinaus ist bei Verwendung von Wechselspannungsquellen anstelle von Gleichspannungsquellen darauf zu achten, daß deren Spannungen gleichphasig sind. Derartige Wechselspannungsquellen werden beispielsweise mit zwei durch eine Signalquelle angesteuerte Verstärker mit unterschiedlichen Verstärkungen realisiert.

Die Erfindung wird nachfolgend anhand der in den Figuren der Zeichnung dargestellten Ausführungsbeispiele näher erläutert. Es zeigen

Figur 1    ein allgemeines Ausführungsbeispiel eines erfindungsgemäßen Netzwerkes,
Figur 2    den Verlauf der Schaltphasen bei dem Netzwerk nach Figur 1 und
Figur 3    eine Anwendung der Erfindung bei einem bekannten Sigma-Delta-Modulator.

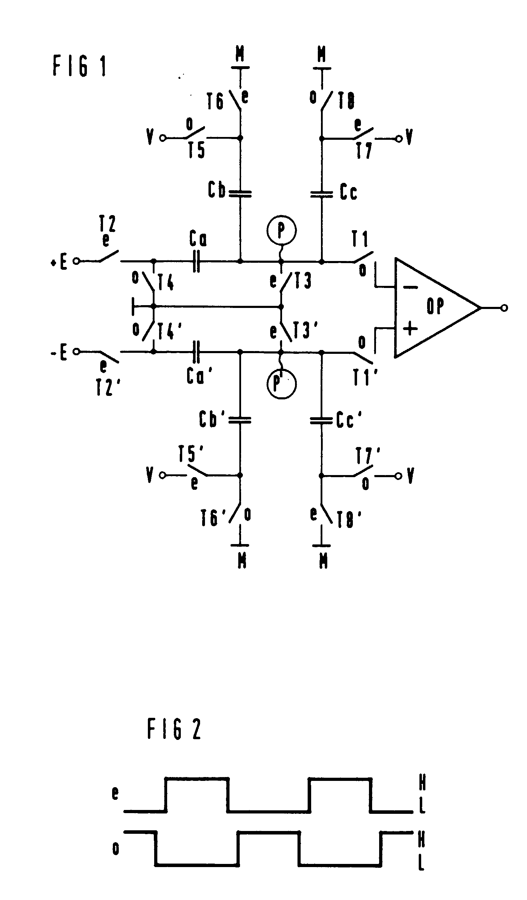

Bei dem Ausführungsbeispiel nach Figur 1 ist der invertierende Eingang eines Operationsverstärkers OP über einen Schalter T1, einen Kondensator Ca und einen Schalter T2 in Reihe mit einem Eingangsanschluß verbunden, an dem ein Signal +E angelegt ist. Dementsprechend ist der nichtinvertierende Eingang des Operationsverstärkers OP über einen Schalter T1', einen Kondensator Ca' und einen Schalter T2' in Reihe mit einem weiteren Eingangsanschluß verbunden, an den ein Signal -E angelegt ist. Die beiden Anschlüsse der Kondensatoren Ca und Ca' sind über jeweils einen Schalter T3 bzw. T3'und T4 bzw. T4' auf ein Bezugspotential M aufschaltbar. Die Signale +E und -E bilden dabei ein bezüglich des Bezugspotentials M symmetrisches Signal. An dem Knotenpunkt P bzw. P' des dem jeweils dem Operationsverstärker OP nächstliegenden Anschlusses des Kondensators Ca bzw. Ca' sowie den zugehörigen Anschlüssen der Schalter T1 und T3 bzw. T1' und T3' ist zudem jeweils der Anschluß eines Kondensators Cb bzw. Cb' angekoppelt, deren jeweils anderer Anschluß über einen Schalter T5 bzw. T5' auf ein Referenzpotential V und über jeweils einen Schalter T6 bzw. T6' auf das Bezugspotential M aufschaltbar ist.

Zur Unterdrückung der signalabhängigen Störungen am Knotenpunkt P' wird erfindungsgemäß ein weiterer Kondensator Cc' mit gleicher Kapazität wie der Kondensator Cb' vorgesehen, der gleichphasig zum Kondensator Cb mittels der Schalter T7' und T8' geladen und entladen wird. Um jedoch auch in der Ladephase des Kondensators Cb', während der Operationsverstärker OP mittels der Schalter T1 und T1' abgekoppelt ist, eine identische Belastung der die Referenzspannung V erzeugenden Referenzspannungsquelle zu gewährleisten, wird zudem ein Kondensator Cc mit gleicher Kapazität wie der Kondensator Cb' vorgesehen und zu diesem gleichphasig mittels der Schalter T7 und T8 geladen und entladen. Da aufgrund der Symmetrie der Schaltung die Schalter T1 bis T6 identisch zu den Schaltern T1' bis T6', sowie die Kondensatoren Ca und Cb identisch zu den Kondensatoren Ca' und Cb' ausgeführt sind, so sind dementzufolge die Kondensatoren Cb, Cb', Cc und Cc' sowie die Schalter T7, T7', T8 und T8' ebenfalls einander identisch. Dabei werden die Schalter T2, T2', T3, T3', T5', T6, T7, T8' durch ein Taktsignal e und die Schalter T1, T1', T4, T4', T5, T6', T7' und T8 durch ein Taktsignal o gesteuert.

Die Schaltphasen sämtlicher Schalter T2, T2', T3, T3', T5', T6, T7, T8', T1, T1', T4, T4', T5, T6', T7', T8 entsprechen dabei den Pegeln H der Taktsignale e und O. Die zeitliche Zuordnung beider Phasen ist in Figur 2 der Zeichnung dargestellt. Danach erfolgt fortlaufend die Generierung von Signalen entgegengesetzter Phase. Zunächst ist das Taktsignal e auf hohem Pegel H und das Taktsignal o auf niedrigem Pegel L. Nach einem Signalwechsel des Taktsignals e erfolgt nach kurzer Verzögerungszeit ein Signalwechsel des Taktsignals o von niedrigem Pegel L zu hohem Pegel H. Für eine bestimmte Zeit führt nun das Taktsignal o das Taktsignal H. Nach dem Signalübergang von Pegel H nach Pegel L des Taktsignals o erfolgt nach kurzer Verzögerungszeit ein Signalwechsel von Pegel L nach Pegel H bei dem Taktsignal e. Nun führt wiederum das Taktsignal e für eine gegebene Zeit den Pegel H bis wiederum ein Wechsel erfolgt undsoweiter.

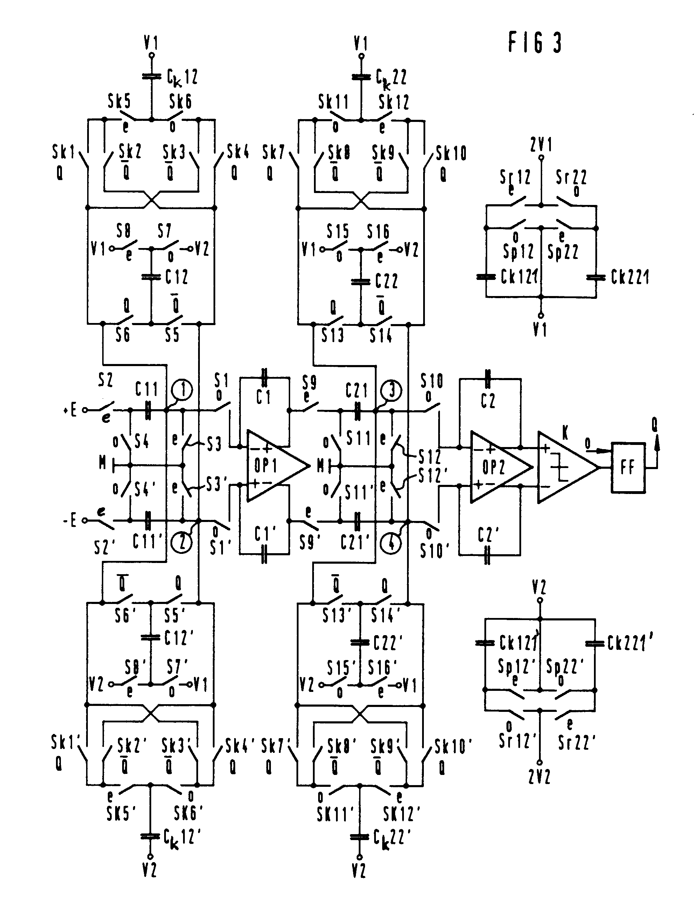

Die Erfindung wird nachfolgend bei dem aus der europäischen Offenlegungsschrift 0 396 786 bekannten Sigma-Delta-Modulator in Switched-Capacitor-Technik angewendet. Gemäß Figur 3 sind bei dem bekannten Sigma-Delta-Modulator zwei Operationsverstärker OP1 und OP2 vorgesehen. Beim Operationsverstärker OP1 ist zwischen nichtinvertiertem Ausgang und invertierendem Eingang eine Kapazität C1 und zwischen invertiertem Ausgang und nichtinvertierendem Eingang eine Kapazität C1' geschaltet. Der invertierende Eingang des Operationsverstärkers OP1 ist zudem über einen Schalter S1, über einen Kondensator C11 und über einen Schalter S2 mit einem Eingang +E und der nichtinvertierende Eingang des Operationsverstärkers OP1 über einen Schalter S1', über einen Kondensator C11' und über einen Schalter S2' mit einem Eingang -E verbunden. Darüber hinaus ist der dem Eingang +E zugewandte Anschluß des Kondensators C11 über einen Schalter S4 und dessen dem Eingang +E abgewandter Anschluß über einen Schalter S3 auf das Bezugspotential M aufschaltbar. Entsprechend ist der dem Eingang - E zugewandte Anschluß des Kondensators C11' über einen Schalter S4' und dessen dem Eingang -E abgewandter Anschluß über einen Schalter S3' auf das Bezugspotential M aufschaltbar.

Der durch den Kondensator C11, den Schalter S3 und den Schalter S1 gebildete Knotenpunkt ist zum einen über einen Schalter S6 mit einem Kondensator C12 und zum anderen über einen Schalter S6' mit einem Kondensator C12' verbunden. Ebenso ist der durch den Kondensator C11', dem Schalter S3' und dem Schalter S1' gebildete Knotenpunkt über einen Schalter S5 mit dem Kondensator C12 und über einen Schalter S5' mit dem Kondensator C12' verbunden. Der jeweils andere Anschluß der Kondensatoren C12 und C12' ist zum einen über einen Schalter S8 bzw. S7' auf ein Potential V1 und über einen Schalter S7 bzw. S8' auf ein Potential V2 aufschaltbar.

Beim Operationsverstärker OP2 ist zwischen nichtinvertiertem Ausgang und invertierendem Eingang ein Kondensator C2 und zwischen invertiertem Ausgang und nichtinvertierendem Eingang ein Kondensator C2' geschaltet. Der nichtinvertierte Ausgang des Operationsverstärkers OP1 ist über einen Schalter S9, einen Kondensator C21 und einen Schalter S10 mit dem invertierenden Eingang des Operationsverstärkers OP2 verbunden. In gleicher Weise ist der invertierte Ausgang des Operationsverstärkers OP1 über einen Schalter S9', einen Kondensator C21' und einen Schalter S10' mit dem nichtinvertierenden Eingang des Operationsverstärkers OP2 verbunden. Darüber hinaus sind die dem Operationsverstärker OP1 zugewandten Anschlüsse der beiden Kondensatoren C21 und C21' über den Schalter S11 bzw. S11' und die dem Operationsverstärker OP2 abgewandten Anschlüsse über jeweils einen Schalter S12 bzw. S12' auf das Bezugspotential M aufschaltbar. An den durch den Kondensator C21, dem Schalter S12 und dem Schalter S10 gebildeten Knotenpunkt ist über einen Schalter S13 ein Kondensator C22 und über einen Schalter S13' ein Kondensator C22' angeschlossen.

Ebenso steht der durch den Kondensator C21', dem Schalter S12' und dem Schalter S10' gebildete Knotenpunkt über einen Schalter S14 mit dem Kondensator C22 und über einen Schalter S14' mit einem Kondensator C22' in Verbindung. Der andere Anschluß des Kondensators C22 bzw. C22' ist zum einen über einen Schalter S15 bzw. S16' auf das Potential V1 und über einen Schalter S14 bzw. S13' auf ein Potential V2 aufschaltbar.

Der nichtinvertierte Ausgang des Operationsverstärkers OP2 ist mit dem nichtinvertierenden Eingang eines Komparators K und der invertierte Ausgang des Operationsverstärkers OP2 mit dem invertierenden Eingang des Komparators K gekoppelt. Der Ausgang des Komparators K ist auf den Eingang eines als Speicherelement vorgesehenen Flip-Flops FF geführt, wobei am Ausgang des Flip-Flops FF ein Ausgangssignal Q anliegt.

Mit dem Taktsignal e werden die Schalter S2, S2', S3, S3', S8, S8', S9, S9', S12, S12', S16, S16' und der Komparator K gesteuert. Entsprechend werden die Schalter S1, S1', S4, S4', S7, S7', S11, S11', S10, S10', S15, 515' und das Flip-Flop FF mit dem Taktsignal o betrieben. Schließlich sind die Schaltzyklen der Schalter S6, S5', S13, S14' durch das Ausgangssignal Q und die Schaltzyklen der Schalter S5, S6', S13', S14 durch das invertierte Ausgangssignal $\overline{Q}$ festgelegt. Der Verlauf der Taktsignale e und o ist wiederum Figur 2 zu entnehmen.

Bei dem gezeigten Sigma-Delta-Modulator werden zum einen die Kondensatoren C11, C11', C21 und C21' aus Wechselspannungsquellen geladen, nämlich durch die symmetrischen Eingangssignale +E und -E bzw. durch die symmetrischen Ausgangssignale des Operationsverstärkers OP1. Dagegen werden die Kondensatoren C12, C12', C22 und C22' durch Referenzspannungsquellen aufgeladen, welche die konstanten Potentiale V1 und V2 erzeugen. Bei diesem Sigma-Delta-Modulator führen signalkorrelierte, in den jeweiligen Schaltphasen der Taktsignale e und o unterschiedliche kapazitive Belastungen der Referenzspannungsquellen zu unerwünschten Störsignalen im Signalzweig. So liegt beispielsweise der Kondensator C12 während der Schaltphase des Taktsignals o zum einen am Referenzpotential V2 und zum anderen an dem das virtuelle Bezugspotential bildenden Integratoreingang. Damit wird die das Referenzpotential V2 erzeugende Referenzspannungsquelle belastet und der Integrator mit dem Operationsverstärker OP1 und dem Kondensator C1 gestört. In der Schaltphase des Taktsignals e liegt dagegen der Kondensator C12' zwischen dem Referenzpotential V2 und dem Bezugspotential M und belastet ebenfalls die das Potential V2 erzeugende Referenzspannungsquelle ohne Wirkung jedoch auf das über den Kondensator C11 zugeführte Signal +E. Entsprechende Störungen werden in gleicher Weise auch durch die Kondensatoren C12', C22 und C22' hervorgerufen.

Um die signalabhängige Belastung der Referenzquellen durch die Kondensatoren C12, C12', C22 bzw. C22' zu kompensieren, werden zwischen den durch den Kondensator C11, den Schalter S1 und den Schalter S3 gebildeten Knotenpunkt, im folgenden Knotenpunkt 1 genannt, und das Potential V1 sowie zwischen den durch den Kondensator C11', den Schalter S1' und den Schalter S3' gebildeten Knotenpunkt, im folgenden Knotenpunkt 2 genannt, und das Potential V2 jeweils eine zusätzliche Kondensator-Schalter-Struktur vorgesehen. Ausgehend vom Knotenpunkt 1 führt jeweils ein Schalter Sk1 und ein Schalter Sk3 auf einen Schalter Sk5 bzw. Sk6, die wiederum einerseits miteinander sowie mit einem Anschluß eines Kondensators Ck12 verbunden sind. Der andere Anschluß des Kondensators Ck12 ist an das Potential V1 angeschlossen. Der Knotenpunkt 2 ist jeweils über einen Schalter Sk2 bzw. Sk4 mit dem Schalter Sk5 bzw. Sk6 gekoppelt. Außerdem ist der Knotenpunkt 1 zum einen über einen Schalter Sk1' mit einem Schalter Sk5' sowie durch einen Schalter Sk3' mit einem Schalter Sk6' und der Knotenpunkt 2 zum einen über einen Schalter Sk2' mit dem Schalter Sk5' und andererseits über einen Schalter Sk4' mit dem Schalter Sk6' koppelbar. Die Schalter Sk5' und Sk6' führen auf einen Anschluß eines Kondensators Ck12', an dessen anderen Anschluß das Potential V2 angelegt ist. Die Kondensatoren Ck12 und Ck12' entsprechen in ihrem Aufbau den Kondensatoren C12 bzw. C12'. Dabei werden die Schalter Sk5 und Sk5' durch das Taktsignal e und die Schalter Sk6 und Sk6' durch das Taktsignal o gesteuert.

Zur Steuerung der Schalter Sk1, Sk1', Sk4 und Sk4' ist das Ausgangssignal Q sowie zur Ansteuerung der Schalter Sk2, Sk2', Sk3 und Sk3' ist das invertierte Ausgangssignal Q vorgesehen.

Dementsprechend sind auch zwischen den durch den Kondensator C21, den Schalter S10 und den Schalter S12 gebildeten Knotenpunkt 3 und das Potential V1 sowie zwischen den durch den Kondensator C21 den Schalter S10' und den Schalter S12' gebildeten Knotenpunkt 4 und das Potential V2 derartige Schalter-Kondensator-Strukturen geschaltet. Diese weisen jeweils einen Kondensator Ck22 bzw. Ck22' auf, dessen jeweils einer Anschluß an dem Potential V1 bzw. V2 liegt und dessen anderer Anschluß auf jeweils zwei Schalter Sk11 und Sk12 bzw. Sk11' und Sk12' geführt ist. Die Schalter Sk11 und Sk11' sind dabei über jeweils einen Schalter Sk7 bzw. Sk7' mit dem Knotenpunkt 3 und über jeweils einen Schalter Sk8 bzw. Sk8' mit dem Knotenpunkt 4 koppelbar. Schließlich sind die Schalter Sk12 und Sk12' über jeweils einen Schalter Sk9 bzw. Sk9' auf den Knotenpunkt 3 und durch jeweils einen Schalter Sk10 bzw. Sk10' auf den Knotenpunkt 4 aufschaltbar. Die Schalter Sk7, Sk7', Sk10 und Sk10' werden dabei durch das Ausgangssignal Q und die Schalter Sk8, Sk8', Sk9 und Sk9' durch das invertierte Ausgangssignal Q gesteuert. Schließlich werden die Schalter Sk11 und Sk11' mit dem Taktsignal o und die Schalter Sk12 und Sk12' mit dem Taktsignal e angesteuert. In Folge der Signalinvertierung durch den Integrierer mit dem Operationsverstärker OP1 und den Kondensatoren C1 und C1' werden die den Kondensatoren jeweils nächstgelegenen Schalter Sk11, Sk12 bzw. Sk11', Sk12' gegenüber den entsprechenden Schaltern Sk7, Sk8 bzw. Sk7', Sk8' durch das jeweils andere Taktsignal angesteuert. Die Kondensatoren C12 und C22 sind im übrigen identisch ausgeführt zu den Kondensatoren C12' bzw. C22'.

Zur Kompensation der durch die Einbrüche der Potentiale V1 und V2 hervorgerufenen signalunabhängigen Störungen sind weitere den Kondensatoren C12, C12', C22 und C22' entsprechende, identisch aufgebaute Kondensatoren Ck121, Ck121', Ck221 und Ck221' vorgesehen. Den Kondensatoren Ck121 und Ck221' ist dabei jeweils ein durch das Taktsignal o gesteuerter Schalter Sp12 bzw. Sp22' sowie den Kondensatoren Ck121' und Ck221 jeweils ein durch das Taktsignal e gesteuerter Schalter Sp12' bzw. Sp22 parallel geschaltet, die für ein periodisches Entladen der zugehörigen Kondensatoren sorgen. Der Kondensator Ck121 ist dabei einerseits an das Potential V1 angeschlossen und andererseits unter Zwischenschaltung eines durch das Taktsignal e gesteuerten Schalters Sr12 mit einem Potential 2V1 gekoppelt. Dementsprechend ist der Kondensator Ck121' einerseits mit dem Potential V2 verbunden und andererseits über einen durch das Taktsignal o gesteuerten Schalter Sr12' mit einem Potential 2V2 koppelbar. Demzufolge sind die Kondensatoren Ck221 und Ck221' einerseits mit dem Potential V1 bzw. V2 verbunden und andererseits über jeweils einen durch das Taktsignal o bzw. e gesteuerten Schalter Sr22 bzw. Sr22' mit dem Potential 2V1 bzw. 2V2 aufschaltbar. Die Potentiale 2V1 und 2V2 weisen dabei jeweils den doppelten Wert der Potentiale V1 bzw. V2 auf.

Schließlich weisen die Spannungsquellen zur Erzeugung der Potentiale 2V1 und 2V2 einen zum Übergangswiderstand der Schalter Sr12, Sr12', Sr22 und Sr22' vernachlässigbaren Innenwiderstand auf, so daß zur Anpassung der Widerstände in den jeweiligen Zuleitungspfaden nur diese Übergangswiderstände angepaßt werden müssen. Da die identischen Kondensatoren C12, C12', C22 und C22' mittels jeweils drei identischer Schalter an das Potential V1 bzw. V2 einerseits und das Bezugspotential M andererseits gelegt werden, weisen sie Schalter Sr12, Sr12', Sr22 und Sr22' dementsprechend den dreifachen Übergangswiderstand dazu auf oder sie setzen sich aus drei dazu identischen, in Reihe geschalteten Schaltern zusammen. Die Verwendung möglichst vieler identischer Bauelemente (Schalter, Kondensatoren etc.) wird insbesondere bei einer Realisierung in integrierter Schaltungstechnik angestrebt, da identische Größen mit einer wesentlich höheren relativen Genauigkeit zueinander erzeugt werden können als andere Größenverhältnisse.

**Patentansprüche**

1. Schalter-Kondensator-Netzwerk mit einer Schalteinrichtung (S1, S1' bis S16, S16'; Sk1, Sk1' bis Sk12, Sk12'),
die zwei erste Kondensatoren (C11, C11', C21, C21') gleicher Kapazität wiederholt aus einer Signalspannungsquelle (+E, -E) mit gegenüber einem Bezugspotential (M) entgegengesetzten Polaritäten auflädt, indem für die Ladedauer jeweils ein Anschluß der zwei ersten Kondensatoren (C11, C11', C21, C21') mit dem Bezugspotential (M) verbunden ist, und anschließend über jeweils einen Eingangskreis eines Differenzverstärkers (OP1, OP2) entlädt
die synchron dazu jeweils zwei zweite Kondensatoren (C12, C12', C22, C22') untereinander gleicher Kapazität abwechselnd und zueinander zeitlich gegenphasig aus jeweils einer von zwei Referenzspannungsquellen (V1, V2) mit gegenüber dem Bezugspotential (M) gleichen Polaritäten auflädt und anschließend über jeweils einen Eingangskreis des Differenzverstärkers (OP1, OP2) entlädt, wobei zwei dritte Kondensatoren (Cr12, Cr12', Cr22, Cr22') mit gleicher Kapazität wie die zweiten Kondensatoren (C12, C12', C22, C22') durch die Schalteinrichtung (S1, S1' bis S16, S16'; Sk1, Sk1' bis Sk12, Sk12') zeitlich gegenphasig zu dem jeweils entsprechenden zweiten Kondensator (C12, C12'; C22, C22') aus der entsprechenden Referenzspannungsquelle (V1, V2) mit gegenüber dem Bezugspotential (M) gleichen Polaritäten aufgeladen und anschließend über jeweils einen Eingangskreis des Differenzverstärkers (OP1, OP2) entladen werden.

2. Switched-Capacitor-Netzwerk nach Anspruch 1, **gekennzeichnet durch** zwei vierte Kondensatoren (Ck121, Ck121', Ck221, Ck221'), die mittels einer zusätzlichen Schalteinrichtung (Sr12, Sr12', Sp12, Sp12', Sr22, Sr22', Sp22, Sp22') jeweils synchron zu einem der beiden zweiten Kondensatoren (C12, C12', C22, C22') geladen und entladen werden und die zum Laden zwischen die Referenzspannungsquelle (V1, V2) und eine weitere Referenzspannungsquelle geschaltet werden, wobei das Produkt aus der Kapazität jedes zweiten Kondensators (C12, C12', C22, C22') und der Spannung der ersten Referenzspannungsquelle (V1, V2) gleich dem Produkt aus der Kapazität jedes vierten Kondensators (Ck121, Ck121', Ck221, Ck221') und der Spannungsdifferenz beider Spannungsquellen (V1, V2, 2V1, 2V2) ist und das Produkt aus der Kapazität jedes zweiten Kondensators (C12, C12', C22, C22') und dem Übergangswiderstand der Schalteinrichtung (S1, S1' bis S16, S16'; Sk1, Sk1' bis Sk12, Sk12') im jeweiligen Zuleitungspfad gleich dem Produkt aus der Kapazität jedes vierten Kondensators (Ck121, Ck121', Ck221, Ck221') und der Summe des Innenwiderstandes der weiteren Referenzspannungsquelle 2V1, 2V2 und des Übergangswiderstandes der weiteren Schalteinrichtung (Sr12, Sr12', Sp12, Sp12', Sr22, Sr22', Sp22, Sp22') im Zuleitungspfad jedes vierten Kondensators (Ck121, Ck121', Ck221, Ck221') ist.

**Claims**

1. Switched-capacitor network having a switching device (S1, S1' to S16, S16'; Sk1, Sk1' to Sk12, Sk12'), which switching device charges two first capacitors (C11, C11', C21, C21') having the same capacitance repeatedly from a signal voltage source (+E, -E) with opposite polarities with respect to a reference-earth potential (M) by connecting a respective terminal of the two first capacitors (C11, C11', C21, C21') to the reference-earth potential (M) for the charging duration, and subsequently discharges them via a respective input circuit of a differential amplifier (OP1, OP2),
which switching device, synchronously therewith, charges two respective second capacitors (C12, C12', C22, C22') having a mutually identical capacitance alternately and temporally in antiphase with one another from a respective one of two reference voltage sources (V1, V2) with identical polarities with respect to the reference-earth potential (M) and subsequently discharges them via a respective input circuit of the differential amplifier (OP1, OP2), two third capacitors (Cr12, Cr12', Cr22, Cr22') having the same capacitance as the second capacitors (C12, C12', C22, C22') being charged, by means of the switching device (S1, S1' to S16, S16'; Sk1, Sk1' to Sk12, Sk12'), temporally in antiphase with the respectively corresponding second capacitor (C12, C12'; C22, C22') from the corresponding reference voltage source (V1, V2) with identical polarities with respect to the reference-earth potential (M) and subsequently being discharged via a respective input circuit of the differential amplifier (OP1, OP2).

2. Switched-capacitor network according to Claim 1, characterized by two fourth capacitors (Ck121, Ck121', Ck221, Ck221'), which are charged and discharged, by means of an additional switching device (Sr12, Sr12', Sp12, Sp12', Sr22, Sr22', Sp22, Sp22'), respectively synchronously with one of the two second capacitors (C12, C12', C22, C22') and are connected between the reference voltage source (V1, V2) and a further reference voltage source in order to be charged, the product of the capacitance of each second capacitor (C12, C12', C22, C22') and the voltage of the first reference voltage source (V1, V2) being equal to the product of the capacitance of each fourth capacitor (Ck121, Ck121', Ck221, Ck221') and the voltage difference between the two voltage sources (V1, V2, 2V1, 2V2), and the product of the capacitance of each second capacitor (C12, C12', C22, C22') and the contact resistance of the switching device (S1, S1' to S16, S16'; Sk1, Sk1' to Sk12, Sk12') in the respective lead path being equal to the product of the capacitance of each fourth capacitor (Ck121, Ck121', Ck221, Ck221') and the sum of the internal resistance of the further reference voltage source 2V1, 2V2 and the contact resistance of the further switching device (Sr12, Sr12', Sp12, Sp12', Sr22, Sr22', Sp22, Sp22') in the lead path of each fourth capacitor (Ck121, Ck121', Ck221, Ck221').

## Revendications

1.  Circuit à capacités commutées, comprenant un dispositif de commutation (S1, S1' à S16, S16'; Sk1, Sk1' à Sk12, Sk12')

    qui charge à plusieurs reprises deux premiers condensateurs (C11, C11', C21, C21') de même capacité à partir d'une source de tension de signal (+E, - E) avec des polarités inverses par rapport à un potentiel de référence (M), pour la durée de charge respectivement une borne des deux premiers condensateurs (C11, C11', C21, C21') étant reliée au potentiel de référence (M), et les décharge ensuite par l'intermédiaire de respectivement un circuit d'entrée d'un amplificateur différentiel (OP1, OP2),

    qui charge de manière synchrone respectivement deux deuxièmes condensateurs (C12, C12', C22, C22') de même capacité, en alternance et en opposition de phase l'un par rapport à l'autre dans le temps, à partir de respectivement une de deux sources de tension de référence (V1, V2), avec les mêmes polarités par rapport au potentiel de référence (M), et les décharge ensuite par l'intermédiaire de respectivement un circuit d'entrée de l'amplificateur différentiel (OP1, OP2), deux troisièmes condensateurs (Cr12, Cr12', Cr22, Cr22') de même capacité que les deuxièmes condensateurs (C12, C12', C22, C22'), en opposition de phase dans le temps par rapport au deuxième condensateur (C12, C12', C22, C22') correspondant, étant chargés par le dispositif de commutation (S1, S1' à S16, S16'; Sk1, Sk1' à Sk12 Sk12') à partir de la source de tension de référence (V1, V2) correspondante avec les mêmes polarités par rapport au potentiel de référence (M) et déchargés ensuite par l'intermédiaire de respectivement un circuit d'entrée de l'amplificateur différentiel (OP1, OP2).

2.  Circuit à capacités commutées selon la revendication 1, caractérisé par deux quatrièmes condensateurs (Ck121, Ck121', Ck221, Ck221') qui, au moyen d'un dispositif de commutation supplémentaire (Sr12, Sr12', Sp12, Sp12', Sr22, Sr22', Sp22, Sp22'), sont chargés et déchargés à chaque fois de manière synchrone par rapport à l'un des deux deuxièmes condensateurs (C12, C12', C22, C22') et qui, pour permettre la charge, sont montés entre la source de tension de référence (V1, V2) et une autre source de tension de référence, le produit de la capacité de chaque deuxième condensateur (C12, C12', C22, C22') et de la tension de la première source de tension de référence (V1, V2) étant égal au produit de la capacité de chaque quatrième condensateur (Ck121, Ck121', Ck221, Ck221') et de la différence de tension entre les deux sources de tension (V1, V2, 2V1, 2V2), et le produit de la capacité de chaque deuxième condensateur (C12, C12', C22, C22') et de la résistance de contact du dispositif de commutation (S1, S1' à S16, S16', Sk1, Sk1' à Sk12, Sk12') dans le chemin d'amenée respectif étant égal au produit de la capacité de chaque quatrième condensateur (Ck121, Ck121', Ck221, Ck221') et de la somme de la résistance interne de l'autre source de tension de référence (2V1, 2V2) et de la résistance de contact de l'autre dispositif de ccmmutation (Sr12, Sr12', Sp12, Sp12', Sr22, Sr22', Sp22, Sp22') dans le chemin d'amenée de chaque quatrième condensateur (Ck121, Ck121', Ck221, Ck221').

FIG 1

FIG 2

FIG 3